## Europäisches Patentamt
## European Patent Office
## Office européen des brevets

(11) Numéro de publication: **0 072 593**

**A1**

# DEMANDE DE BREVET EUROPEEN

(21) Numéro de dépôt: **82201004.7**

(22) Date de dépôt: **11.08.82**

(51) Int. Cl.³: **H 03 L 7/18**

(30) Priorité: **14.08.81 FR 8115719**

(43) Date de publication de la demande:
**23.02.83 Bulletin 83/8**

(84) Etats contractants désignés:
**BE CH DE FR GB IT LI SE**

(71) Demandeur: **TELECOMMUNICATIONS RADIOELECTRIQUES ET TELEPHONIQUES T. R. T.**
**88, rue Brillat Savarin**
**F-75013 Paris(FR)**

(84) Etats contractants désignés:
**FR**

(71) Demandeur: **N.V. Philips' Gloeilampenfabrieken**
**Groenewoudseweg 1**
**NL-5621 BA Eindhoven(NL)**

(84) Etats contractants désignés:
**BE CH DE GB IT LI SE**

(72) Inventeur: **Pertoldi, Jean-Marc**
**Société Civile S.P.I.D. 209 rue de l'Université**
**F-75007 Paris(FR)**

(74) Mandataire: **Chaffraix, Jean et al,**
**Société Civile S.P.I.D. 209, rue de l'Université**
**F-75007 Paris(FR)**

(54) **Dispositif de verrouillage de phase pour fournir à sa sortie des signaux dont la fréquence peut varier sur une large gamme.**

(57) Ce dispositif de verrouillage de phase est prévu pour fournir à sa borne de sortie (20) des signaux dont la fréquence peut varier sur une large gamme; ce dispositif comporte un VCO (10), un détecteur de phase (30), un filtre passe-bas (45) prévu pour déterminer les caractéristiques de fonctionnement dudit dispositif, un diviseur de fréquence (25). Selon l'invention, ce dispositif comporte, en outre, un circuit de variation de gain (60) pour faire varier la valeur du signal de sortie du détecteur de phase et un circuit (62) qui mesure la valeur du signal appliqué à la commande de fréquence du VCO pour faire varier le gain du circuit de variation afin de garder pratiquement constantes lesdites caractéristiques dans la gamme.

*Application*: aux synthétiseurs de fréquences.

FIG.1

EP 0 072 593 A1

1

## DISPOSITIF DE VERROUILLAGE DE PHASE POUR FOURNIR A SA SORTIE DES SIGNAUX DONT LA FREQUENCE PEUT VARIER SUR UNE LARGE GAMME

La présente invention concerne un dispositif de verrouillage de phase pour fournir à sa borne de sortie des signaux dont la fréquence peut varier sur une large gamme, dispositif comportant un oscillateur à commande de fréquence par tension (VCO) dont la sortie constitue ladite borne de sortie, un détecteur de phase destiné à fournir des signaux de différence de phase pour la commande de fréquence du VCO par l'intermédiaire d'un filtre passe-bas, filtre prévu pour déterminer les caractéristiques de fonctionnement dudit dispositif, un diviseur de fréquence variable connecté entre ladite sortie du VCO et une entrée du détecteur de phase et un oscillateur de référence dont la sortie est connectée à une autre entrée du détecteur de phase.

De tels dispositifs sont bien connus dans la technique. Ils sont utilisés notamment comme synthétiseurs de fréquences pour fournir des signaux dont la fréquence peut varier rapidement et prendre des valeurs précises.

Une des exigences que l'on impose généralement aux signaux de sortie de ces dispositifs est d'avoir une certaine pureté spectrale ; or cette pureté n'est obtenue qu'en choisissant des valeurs bien déterminées des caractéristiques de fonctionnement (notamment la fréquence naturelle et le facteur d'amortissement) qui règlent le comportement des dispositifs. Les caractéristiques dépendent du rapport de division et aussi de la non linéarité du VCO

2

constitué le plus souvent à partir d'une diode à capacité variable. La valeur de ces caractéristiques choisies ne peut être garantie d'une extrémité à l'autre de la gamme.

La présente invention propose un dispositif du genre mentionné qui ne présente pas cet inconvénient de variation de caractéristiques d'une extrémité à l'autre de la gamme.

Pour cela, un tel dispositif est remarquable en ce qu'il comporte, en outre, un circuit de variation de gain pour faire varier la valeur du signal de sortie du détecteur de phase et un circuit de mesure du signal appliqué à la commande de fréquence du VCO pour faire varier le gain du circuit de variation afin de garder pratiquement constantes lesdites caractéristiques dans la gamme.

La description suivante faite en regard des dessins annexés fera bien comprendre comment l'invention peut être réalisée.

La figure 1 montre un schéma de principe d'un dispositif conforme à l'invention.

La figure 2 montre un schéma fonctionnel du dispositif de la figure 1.

La figure 3 montre une courbe de VCO (tension fréquence).

La figure 4 montre un exemple de réalisation de différents constituants d'un dispositif conforme à l'invention.

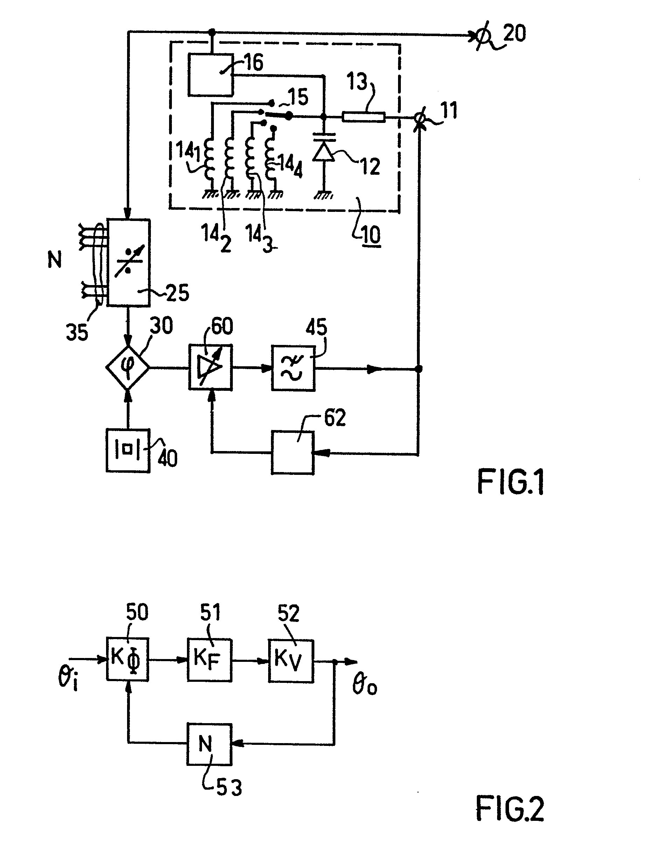

Le dispositif montré à la figure 1 est constitué, tout d'abord, par un oscillateur à commande de fréquences par tension (VCO) ; cet oscillateur porte la référence 10 et la borne de commande de fréquence la référence 11. A cette borne, on applique une tension qui agit sur une diode à capacité variable 12, par l'intermédiaire d'une résistance 13. Cette diode 12 avec l'une des bobines de self-induction $14_1$, $14_2$, $14_3$, $14_4$, connectée en parallèle au moyen d'un commutateur 15, fixe la fréquence de l'oscillateur. Le circuit actif de l'oscillation est représenté par le carré référencé par 16 ; on prélève dans ce circuit 16 l'oscillation pour la fournir à l'utilisation par l'intermédiaire de la borne 20. Un diviseur de fréquence 25 interconnecte cette borne 20 à une première entrée d'un détecteur de phase 30. Ce diviseur 25 divise la fréquence du VCO par un nombre N variable en fonction des besoins de l'utilisation. Ce nombre N est affiché sur des commandes de division 35 dont est muni le diviseur 25. La sortie d'un oscillateur de référence 40 est reliée à la deuxième entrée du détecteur de phase 30. Le signal de sortie de ce détecteur est filtré par le filtre 45 avant d'être appliqué à la commande 11.

Le dispositif de la figure 1 est montré d'une manière fonctionnelle sous forme de boucle à la figure 2. Sur cette figure 2, les différentes cases 50, 51, 52, 53 représentent les fonctions de transfert des différents constituants du dispositif de la figure 1.

La case 50 représente le gain $K_\phi$ du détecteur de phase 30.

La case 51 représente la fonction de transfert $K_F$ du filtre 45.

La case 52 représente le facteur de conversion $K_V$ du VCO 10, c'est-à-dire le rapport entre la fréquence et la tension.

La case 53 représente le diviseur N par lequel l'organe 25 divise sa fréquence d'entrée.

Si $\theta_i$ représente la phase à une entrée du détecteur 30 et $\theta_o$ la phase de l'onde à la sortie 20,

On peut écrire :

$$\frac{\theta_o(s)}{\theta_i(s)} = \frac{K_\phi\, K_F\, K_V}{s + \dfrac{K_\phi\, K_F\, K_V}{N}} \qquad (1)$$

Si on prend un filtre 45 tel que sa fonction de transfert s'écrit par exemple:

$$K_F = \frac{1 + T1\, s}{T2} \qquad (2)$$

où "s" est l'opérateur de LAPLACE et T1 et T2 des constantes de temps, on montre que le comportement de la boucle est défini par deux caractéristiques : $\omega_n$ fréquence naturelle et $\xi$ facteur d'amortissement.

$$\omega_n = \frac{K_\phi K_V}{NT2} \qquad (3)$$

$$\xi = \frac{K_\phi K_V}{NT2} \cdot \frac{T1}{2} \qquad (4)$$

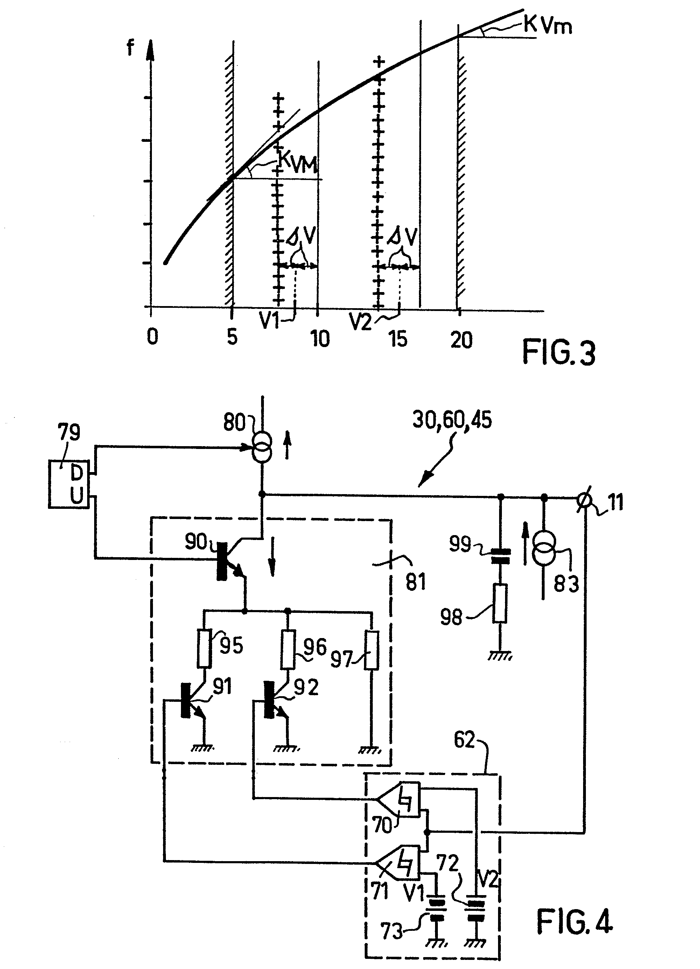

On voit que ces paramètres varient en fonction de N et aussi de $K_V$. La figure 3 montre un exemple de la variation de la fréquence f en fonction de la tension appliquée à la commande du VCO 1, le coefficient $K_V$ est la pente de la fonction et, sur la figure 3, on constate que cette pente varie d'un bout à l'autre de la plage d'oscillation entre une valeur $K_{VM}$ et $K_{Vm}$, ceci va encore aggraver les variations de ces paramètres puisque pour la fréquence la plus basse, N est faible et $K_V = K_{VM}$ et, pour la fréquence la plus haute, N est fort et $K_V = K_{Vm}$.

Conformément à l'invention, le dispositif de la figure 1 comporte, en outre, un circuit de variation de gain 60 pour faire varier la valeur du signal de sortie du détecteur de phase 30 et un circuit de mesure 62 du signal appliqué à la commande 11 du VCO 10 pour faire varier le gain du circuit 60 afin de garder pratiquement constantes lesdites caractéristiques.

Le principe de l'invention repose sur les considérations suivantes.

On appelle :

- C (V) la courbe représentant la capacité d'une diode à capacité variable en fonction de la tension (V) appliquée à ses extrémités,

- k un facteur représentant le nombre de diodes à capacité variable. Par exemple, $k = \frac{1}{2}$ pour deux diodes montées en série et k = 2 pour deux diodes montées en parallèle,

- L l'inductance des bobines $14_1$, $14_2$, $14_3$ ou $14_4$.

La fréquence "f" d'accord du circuit oscillant s'écrit alors :

$$f = \frac{1}{2\pi \sqrt{L}} \cdot \frac{1}{\sqrt{k} \sqrt{C(V)}} \qquad (5)$$

le coefficient $K_V$ peut s'écrire :

$$K_V = \frac{df}{dV} = \frac{1}{2\pi \sqrt{L} \sqrt{k}} \times \left(-\frac{1}{2}\right) \times \frac{1}{C(V)^{3/2}} \times \frac{d\left[C(V)\right]}{dV} \qquad (6)$$

ou compte tenu de (5) :

$$K_V = f \times \left(-\frac{1}{2}\right) \times \frac{1}{C(V)} \times \frac{d\left[C(V)\right]}{dV} \qquad (7)$$

en divisant (7) par N :

$$\frac{K_V}{N} = \frac{f}{N} \times \left(-\frac{1}{2}\right) \times \frac{1}{C(V)} \times \frac{d\left[C(V)\right]}{dV} \qquad (8)$$

Or, $\frac{f}{N}$ est la fréquence du signal fourni par l'oscillateur 40, c'est donc une constante. Par l'invention, on peut rendre constante la quantité :

$$\frac{1}{C(V)} \times \frac{d\left[C(V)\right]}{dV} \qquad (9)$$

quelles que soient les valeurs de V, sans tenir compte de L et de k en jouant sur la valeur du gain de la boucle.

Ainsi, pour toutes les gammes définies par la mise dans le circuit des selfs $14_1$, $14_2$, $14_3$ ou $14_4$, la compensation, selon l'invention, de la quantité (9) est la même et rend constante, donc, la quantité $\frac{K_v}{N}$ qui intervient dans les équations (3) et (4) définissant les caractéristiques $\omega_n$ et $\xi$.

A la figure 4, on montre en détail, d'une part, la réalisation des circuits 30, 60, 45 qui sont combinés et, d'autre part, la réalisation du circuit 62.

Le circuit 62 se compose de deux comparateurs 70 et 71 comparant la tension à la borne 11 avec deux sources de tension 72 et 73 fournissant respectivement une tension V1 et V2 à leurs bornes. Ces comparateurs 70 et 71 présentent une certaine hystérésis $\Delta V$ de part et d'autre de la tension de référence : c'est-à-dire lorsque la tension à la borne 11 part de la tension 0 volt, les comparateurs 70 et 71 fournissent à leur sortie leur tension de saturation positive puis, lorsque la tension à la borne 11 atteint la valeur V1 + $\Delta V$ la tension de sortie du comparateur 71 passe à 0 volt, puis, lorsque la tension à la borne 11 atteint la valeur V2 + $\Delta V$ c'est au tour de la tension de sortie du comparateur 70 de prendre la valeur 0 volt. Lorsque la tension descend, il faut atteindre respectivement les valeurs V2 − $\Delta V$ et V1 − $\Delta V$ pour faire changer la tension de sortie des comparateurs 70 et 71. Ces deux tensions V1 et V2 déterminent trois zones pour la caractéristique fréquence-tension du VCO ; ceci est suffisant en pratique.

Le détecteur de phase 30 est élaboré à partir d'un détecteur de fréquence et de phase 79 (circuit MOTORALA MC 4 344 ou MC 4 044). Ce circuit comporte deux sorties U et D. La sortie D commande la mise en route d'un générateur de courant 80 représenté symboliquement tandis que la sortie U commande un générateur de courant 81 représenté en détail. Pour expliquer le fonctionnement d'un tel circuit, on peut se référer à l'article de Floyd M. GARDNER paru dans la revue IEEE Transactions on Communications, vol. COM 28, n° 11 de Novembre 1980 et intitulé : "Charge − Pump Phase − Lock Loops". Cependant, il convient de remarquer que le montage représenté à la figure 4, à la différence de ceux décrits

dans ledit article, n'est pas symétrique du fait de la présence d'un générateur de courant 83 injectant un courant au niveau de la borne 11 ; ainsi, à la condition d'équilibre de la boucle, seule la sortie U est active et stabilise le circuit avec une différence de phase de, par exemple, 10 degrés. La sortie D n'est alors active que pour la phase d'acquisition. Ainsi, à l'équilibre, le générateur de courant 81 pourra fournir des courants de différentes valeurs en fonction des signaux de sortie du circuit 62. Ce générateur de courant est constitué tout d'abord d'un premier tran- sistor 90 dont le collecteur est connecté à la borne 11, la base, à la sortie U du circuit 79 et dont l'émetteur est connecté au collecteur de deuxième et troisième transistors 91 et 92, par l'in- termédiaire de résistances 95 et 96. L'émetteur du transistor 90 est aussi connecté à l'extrémité d'une résistance 97 dont l'autre extrémité est connectée à la masse. Les émetteurs des transistors 91 et 92 sont connectés également à la masse, tandis que leurs bases sont connectées respectivement aux sorties des comparateurs 70 et 71 du circuit 62.

Le fonctionnement du générateur de courant est le suivant :

La valeur du courant est déterminée par les valeurs des résistances 95, 96 et 97. Les valeurs des résistances 95 et 96 ne participent que si les transistors 91 et 92, se comportant comme des interrupteurs, sont rendus conducteurs. En se reportant à l'article précité, on voit que la valeur de courant fourni par le générateur 81 est liée proportionnellement à la valeur du gain de la boucle. Le circuit branché entre la borne 11 et la masse, formé de la résistance 98 et du condensateur 99 en série, détermine la fonction de transfert du circuit 45, mais aussi constitue un filtre des impulsions de courant fourni par les générateurs 80 et 81.

REVENDICATIONS :

1. Dispositif de verrouillage de phase pour fournir à sa borne de sortie des signaux dont la fréquence peut varier sur une large gamme, dispositif comportant un oscillateur à commande de fréquence dit VCO dont la sortie constitue ladite borne de sortie, un détecteur de phase destiné à fournir des signaux de différence de phase pour la commande de fréquence du VCO par l'intermédiaire d'un filtre passe-bas prévu pour déterminer les caractéristiques de fonctionnement dudit dispositif, un diviseur de fréquence variable connecté entre la sortie dudit VCO et une entrée du détecteur de phase et un oscillateur de référence dont la sortie est connectée à une autre entrée du détecteur de phase, caractérisé en ce qu'il comporte, en outre, un circuit de variation de gain pour faire varier la valeur du signal de sortie du détecteur de phase et un circuit de mesure du signal appliqué à la commande de fréquence du VCO pour faire varier le gain du circuit de variation afin de garder pratiquement constantes lesdites caractéristiques dans la gamme.

2. Dispositif de verrouillage de phase selon la revendication 1, caractérisé en ce que le détecteur de phase et le filtre sont constitués par un réseau d'intégration d'impulsions de courant calibré fournies par au moins un générateur de courant mis en route par des impulsions d'écart de phase et par un circuit pour fournir des impulsions d'écart de phase en fonction de la différence de phase des signaux de sortie du diviseur de fréquence et de l'oscillation de référence.

3. Dispositif de verrouillage de phase selon la revendication 2, caractérisé en ce qu'au moins un générateur de courant est muni d'au moins une borne de commande pour faire varier la valeur du courant calibré, ces bornes de commande étant reliées aux sorties du circuit de mesure.

4. Dispositif de verrouillage de phase selon l'une des revendications 1 à 3, caractérisé en ce que le circuit de mesure est formé d'au moins un comparateur.

5. Dispositif de verrouillage de phase selon la revendication 4, caractérisé en ce que le ou les comparateurs présentent une certaine hystérésis.

FIG.1

FIG.2

FIG.3

FIG.4

Office européen
des brevets

**RAPPORT DE RECHERCHE EUROPEENNE**

EP  82 20 1004

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| | --- | | H 03 L    7/18 |
| X | DE-A-2 706 224   (ROHDE & SCHWARZ) *En entier* | 1-3 | |
| Y | | 4,5 | |
| | --- | | |
| X | PATENTS ABSTRACTS OF JAPAN, vol. 3, no. 66, 7 juin 1979, page 48 E 115; & JP - A - 54 043 666 (NIPPON DENKI K.K.) (06-04-1979) *Page 3, colonne de gauche, ligne 6 - colonne de droite, ligne 8; figure 3* | 1 | |
| Y | PATENTS ABSTRACTS OF JAPAN. | 4,5 | DOMAINES TECHNIQUES RECHERCHES (Int. Cl. ³) |
| | --- | | |
| Y | FR-A-2 401 559   (RCA) *Page 7, ligne 17 - page 12, ligne 2; figure 3* | 4,5 | H 03 L H 03 J |
| | --- | | |
| Y | EP-A-0 012 656   (THOMSON-CSF) *Figure 2* | 4 | |
| | --- | | |
| A | FR-A-1 598 437   (WESTERN ELECTRIC) *Page 1, ligne 26 - page 13, ligne 3; figures 1-3* | 1 | |
| | ---              -/- | | |

Le présent rapport de recherche a été établi pour toutes les revendications

| Lieu de la recherche LA HAYE | Date d'achèvement de la recherche 15-11-1982 | Examinateur DHONDT I.E.E. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82

Office européen
des brevets

**RAPPORT DE RECHERCHE EUROPEENNE**

EP  82 20 1004

| | **DOCUMENTS CONSIDERES COMME PERTINENTS** | | Page  2 |
|---|---|---|---|
| Catégorie | Citation du document avec indication, en cas de besoin, des parties pertinentes | Revendication concernée | CLASSEMENT DE LA DEMANDE (Int. Cl. ³) |
| A | FR-A-2 304 213  (SONY)<br>*Page 3, ligne 12 - page 5, ligne 4; figure 1* | 1 | |
| A | DE-A-2 058 874  (SIEMENS)<br>*Page  1, ligne 1 - page 6, ligne 16; figures 1,4* | 1 | |
| | ----- | | |
| | | | **DOMAINES TECHNIQUES RECHERCHES (Int. Cl. ³)** |
| Le présent rapport de recherche a été établi pour toutes les revendications | | | |

| Lieu de la recherche<br>LA HAYE | Date d'achèvement de la recherche<br>15-11-1982 | Examinateur<br>DHONDT I.E.E. |
|---|---|---|